# EUROPÄISCHE PATENTSCHRIFT

(11) **EP 2 386 125 B1**
(45) Veröffentlichungstag und Bekanntmachung des Hinweises auf die Patenterteilung: **18.10.2017**
(21) Anmeldenummer: 10701094.4
(22) Anmeldetag: 08.01.2010
(51) Int. Cl.: H02S 40/34

(54) **SOLARPANEEL UND VERFAHREN ZU DESSEN HERSTELLUNG**
SOLAR PANEL AND METHOD OF MANUFACTURING THE SAME
PANNEAU SOLAIRE ET PROCÉDÉ POUR SA FABRICATION

(30) Priorität: 08.01.2009 DE 102009004100
(43) Veröffentlichungstag der Anmeldung: 16.11.2011
(73) Patentinhaber: Yamaichi Electronics Deutschland GmbH, 85609 Aschheim-Dornach (DE)
(72) Erfinder: BRAUN, Sven, 80687 München (DE)
(74) Vertreter: Müller-Boré & Partner Patentanwälte PartG mbB
(86) Internationale Anmeldenummer: PCT/EP2010/000064
(87) Internationale Veröffentlichungsnummer: WO 2010/079142

(56) Entgegenhaltungen:
- EP-A1- 1 758 176
- EP-A2- 1 496 577
- EP-A2- 1 587 149
- WO-A1-2006/074561
- DE-A1-102006 019 210
- DE-U1- 20 311 183

## Beschreibung

Die vorliegende Erfindung betrifft ein Solarpaneel und ein Verfahren zum Herstellen eines Solarpaneels.

Herkömmliche Solarmodule zur Erzeugung elektrischer Energie aus Sonnenlicht umfassen eine oder mehrere einzelne Solarzellen. Je nach gewünschter vom Solarmodul zur Verfügung zu stellenden Spannung und/oder Stromstärke werden einzelne Solarzellen innerhalb des Moduls parallel und/oder in Reihe geschaltet und damit zu Solarzellengruppen zusammengefaßt. Die Solarzellengruppen werden zu einem flachen Solarmodul zusammengefaßt.

Die elektrischen Anschlüsse der Solarzellengruppen des Solarmoduls werden nach außen geführt. Bei partieller Verringerung der Bestrahlungsintensität durch Sonnenlicht auf einzelne Solarzellen bzw. Solarzellengruppen, beispielsweise durch Verschmutzung oder Schattenwurf, können unter anderem folgende Effekte auftreten:
(1) Eine (gleichmäßige) Verringerung der Bestrahlungsintensität innerhalb der zusammen geschalteten Solarzellengruppen führt zu einer Leistungsverminderung der jeweiligen Solarzellengruppe.
(2) Durch eine partielle Abschattung einer Solarzelle innerhalb einer Solarzellengruppe wirkt diese abgeschattete Solarzelle als Sperrdiode bzw. Widerstand innerhalb des Stromkreises der Solarzellengruppe, was zum einen dazu führen kann, daß die gesamte Solarzellengruppe keine elektrische Energie mehr liefern kann und zum anderen zu einer Beschädigung der abgeschatteten Solarzelle und damit zum dauerhaften Ausfall der Solarzellengruppe führen kann.

In jedem Fall können zwischen den herausgeführten Anschlüssen der Solarzellengruppen eines Solarmoduls, je nach Bestrahlungsintensität auf die einzelnen Solarzellen, unterschiedliche Spannungen anliegen. Eine Reihenschaltung der Solarzellengruppen durch entsprechende Schaltung der nach außen geführten Anschlüsse führt analog zu den oben genannten Problemen.

Um die mit der unterschiedlichen Bestrahlungsintensität der Solarzellen verbundenen Probleme zu vermeiden, werden herkömmlich sogenannte Bypass-Dioden verwendet, die elektrisch antiparallel zu den Solarzellengruppen geschaltet werden. Diese Bypass-Dioden haben die Wirkung, daß der Stromfluß durch das Solarmodul an Solarzellengruppen, welche eine nur geringe Leistung liefern, vorbei geleitet wird, d.h. die Anschlüsse dieser Solarzellengruppe eines Solarmoduls werden durch die Bypass-Diode kurz geschlossen und die entsprechende Solarzellengruppe dadurch überbrückt. Somit liefert eine solche Solarzellengruppe zwar keinen Anteil mehr zur Gesamtleistung des Solarmoduls, der Gesamtstromfluß durch das Solarpaneel ist jedoch im wesentlichen ungehindert und eine Beschädigung einzelner Solarzellen wird verhindert.

Solarpaneele umfassen daher neben dem Solarmodul in der Regel eine elektrische Anschlußdose mit einer Vielzahl von Kontaktvorrichtungen und einer entsprechend angepaßten Anzahl von Bypass-Dioden. Ferner sind die Solarzellen in einem Solarmodul in der Regel durch flache dünne Leiterbänder miteinander verbunden. Diese Leiterbänder werden aus dem Solarmodul heraus geführt und manuell mit den in der Anschlußdose angeordneten Kontaktvorrichtungen kontaktiert, so daß einerseits der erzeugte Strom aus dem Solarmodul heraus geführt werden kann und andererseits die Solarzellen, falls nötig, überbrückt werden können. Das mit der Anschlußdose versehene Solarmodul wird als Solarpaneel bezeichnet.

DE 10 2006 019 210 A1 offenbart eine Anschlußdosenanordnung für Solarmodule, bei denen die Solarzellen und die Kontaktbahnen zwischen zwei Glasplatten angeordnet und die Kontaktbahnenden durch einen Durchgang in einer der Glasplatten nach außen ragen, wobei die Anschlußdosenanordnung aus dem Solarmodul und einer Anschlußdose besteht, die wenigstens ein dichtes Gehäuse mit darin angeordneten Anschlußkontakten aufweist, die mit Solaranschlußkabeln verbunden sind und die Anschlußkontakte die Verbindung zu den Kontaktbahnenden herstellen, wenn die Anschlußdose auf der Glasplatte im Bereich des Durchganges unlösbar befestigt ist. Im Durchgang der Glasplatte des Solarmoduls ist ein Einsatzteil zur Führung, Zentrierung und Positionierung der Kontaktbahnenden und/oder der Anschlußdose angeordnet, die Anschlußkontakte umfassen die Kontaktbahnenden und kontaktieren diese mehrfach und als Dichtmittel dient in das einteilig ausgebildete Gehäuse eingespritzes Dichtungsmaterial.

Es ist Aufgabe der Erfindung, ein Solarpaneel sowie ein Verfahren zur Herstellung eines Solarpaneels bereitzustellen, welche eine einfache, materialsparende Montage ermöglichen.

Die Aufgabe wird durch die unabhängigen Ansprüche gelöst. Bevorzugte Ausführungsvarianten und/oder Ausführungsformen sind Gegenstand der abhängigen Ansprüche.

### Solarpaneel gemäß einem Aspekt

Ein Aspekt der vorliegenden Erfindung betrifft ein Solarpaneel, umfassend:
- ein Solarmodul mit einem Anschlußseitenelement,
- zumindest eine elektrische Überbrückungseinrichtung, umfassend:
   -- eine Ausnehmung, die in dem Anschlußseitenelement ausgebildet ist,
   -- zumindest zwei elektrische Leiter, die zumindest bereichsweise in der Ausnehmung angeordnet sind,
   -- zumindest eine Diode,
      wobei ein erster der elektrischen Leiter einen zugeordneten ersten Anschluß der Diode unmittelbar kontaktiert und
      wobei ein zweiter der elektrischen Leiter einen zugeordneten zweiten Anschluß der Diode unmittelbar kontaktiert,
      so daß die zwei elektrischen Leiter mittels der zumindest einen Diode elektrisch verbunden sind und
   -- ein Deckelement, welches an dem Anschlußseitenelement befestigt ist und die Ausnehmung sowie die zumindest eine Diode abdeckt.

Vorteilhafterweise ist das Überbrückungselement auf einfache Art und Weise auszubilden. Da insbesondere keine weitere Einrichtung notwendig ist, um die elektrischen Leiter mit der Diode zu kontaktieren, ist das Solarpaneel vorteilhafterweise materialsparend herstellbar. Weiterhin vorteilhafterweise ist es nicht notwendig, die elektrischen Leiter zum Kontaktieren bzw. Verbinden mit der Diode aufzurichten, da die Diode bzw. deren Anschlüsse ohne weitere mechanische Bearbeitung bzw. Bewegung der elektrischen Leiter an diesen angeordnet und damit verbunden, z.B. verlötet werden kann.

Eine Solarzelle ist vorzugsweise zwischen einem Beleuchtungsseitenelement und dem Anschlußseitenelement angeordnet, wobei das Beleuchtungsseitenelement zumindest bereichsweise transparent ist und bevorzugt aus Glas ausgebildet ist.

In anderen Worten ist das Beleuchtungsseitenelement ausgelegt, lichtdurchlässig zu sein. Das Anschlußseitenelement im Sinne der Erfindung beschreibt ein Element, das insbesondere dem Beleuchtungsseitenelement gegenüber liegt. Mittels des Anschlußseitenelements ist das Solarmodul beispielsweise befestigbar bzw. montierbar. Die Solarzelle weist zumindest zwei elektrische Leiter auf, die den Plus- und Minuspol der Solarzelle bilden.

Das Solarmodul kann auch zumindest zwei, d.h. 2, 3, 4, 5, 6, 7, 8, 9, 10, usw. in Reihe geschaltete spannungserzeugende Solarzellen bzw. Solarzellengruppen umfassen, wobei jede Solarzelle zwei elektrische Leiter aufweist, die den Plus- und Minuspol der Solarzelle bilden und die an der Anschlußseite des Solarmoduls aus diesem heraus geführt werden. Folglich umfaßt ein Solarmodul zumindest zwei, d.h. 2, 4, 6, 8, 10, 12, 14, 16, 18, 20, usw. elektrische Leiter.

An dem Anschlußseitenelement ist zumindest eine Ausnehmung ausgebildet. Die Wandung der Ausnehmung kann vorzugsweise zumindest bereichsweise durch das Beleuchtungsseitenelement ausgebildet sein. Insbesondere kann die Ausnehmung durch eine Öffnung bzw. eine Bohrung in dem Anschlußseitenelement, welche einseitig mittels des Beleuchtungsseitenelements geschlossen ist, ausgebildet sein.

Zumindest zwei der elektrischen Leiter des Solarmoduls sind zumindest bereichsweise innerhalb der Ausnehmung angeordnet. Um eine der Solarzellen wie eingangs beschrieben zu schützen, sind der Plus- und Minuspol einer der Solarzellen mittels einer Diode bzw. Bypass-Diode miteinander verbunden, wobei die Diode einen Kurzschluß zwischen den beiden Polen erzeugt, wenn die über die Solarzelle abfallende Spannung einen vorbestimmten Grenzwert überschreitet.

Die Diode kann beispielsweise als Axial-Diode oder als Radial-Diode oder als SMD-Diode ausgeführt sein. Jede Diode umfaßt zumindest zwei Anschlüsse, nämlich einen Eingangsanschluß und einen Ausgangsanschluß. Vorzugsweise weist eine Axial-Diode ein Axial-Gehäuse mit genau zwei Anschlüssen auf, beispielsweise ein Axial-Gehäuse gemäß eines der Gehäusetypen DO-35, DO-41, SC-40, SOD-27, SOD-57, DO-204AH (Gehäuse aus Glas) oder DO-15, DO-41, DO-201AE, DO-210AD, P-6, R-6, P600, DO-204AR (Gehäuse aus Kunststoff) oder DO-1 (Metallgehäuse). Die Anschlüsse der Axial-Diode sind insbesondere als zylindrische Drähte ausgebildet, wobei die beiden Anschlüsse parallel zu einer Längsachse und/oder einer Zylinderachse des Gehäuses angeordnet sein können. Weiter bevorzugt kann die Diode ein kapselförmiges Gehäuse oder Puck-Gehäuse aufweisen, z.B. der Bauform TO-200AB, TO-200AC, TO-200AD oder TO-200AF. Weiter bevorzugt kann die Diode ein Metallgehäuse zum Einpressen aufweisen beispielsweise ein zylindrisches, geriffeltes Gehäuse z.B. aus Kupfer. Weiter bevorzugt kann die Diode ein Plastikgehäuse mit und ohne Kühlfahne oder ein Plastikgehäuse zur Flanschbefestigung aufweisen.

Alternativ kann die Diode ein Gehäuse aufweisen, wobei die Anschlüsse an einer Seite des Gehäuses angeordnet sind, insbesondere senkrecht oder parallel zu einer Längsachse des Gehäuses. In diesem Fall kann die Diode als Radial-Diode bezeichnet werden.

Die zumindest zwei Anschlüsse der Diode sind jeweils unmittelbar mit einem der zumindest zwei elektrischen Leiter kontaktiert. In diesem Zusammenhang beschreibt der Begriff des unmittelbaren Kontaktes, daß zwischen einem der Anschlüsse der Diode und einem der elektrischen Leiter kein Zwischenelement angeordnet ist, somit ein Anschluß der Diode einen elektrischen Leiter direkt mechanisch kontaktieren kann. Ein Befestigungs- bzw. Kontaktierungsmittel, beispielsweise ein Lot, ein Kleber, ein Niet und/oder eine Schraube, mit dem der Anschluß der Diode an dem elektrischen Leiter befestigt ist, ist dagegen kein Zwischenelement im Sinne der Erfindung, d.h., daß beispielsweise ein Lot, ein Kleber, ein Niet und/oder eine Schraube, zumindest bereichsweise zwischen dem Anschluß der Diode und dem elektrischen Leiter angeordnet sein. Unmittelbarer Kontakt kann z.B. auch beinhalten, daß der Anschluß ein Lot, einen Kleber, usw. kontaktiert und der elektrische Leiter dieses Lot, diesen Kleber, usw. kontaktiert. Hierbei kann zusätzlich auch noch direkter mechanischer Kontakt zwischen dem Anschluß und dem elektrischen Leiter vorhanden sein. Gemäß der Erfindung wird jedoch vermieden, daß der Anschluß an einer zusätzlichen Befestigungseinrichtung befestigt ist und mit dieser in elektrischen Kontakt ist und daß der elektrische Leiter an dieser Befestigungseinrichtung befestigt ist und mit dieser in elektrischen Kontakt ist, wobei der Anschluß und der elektrische Leiter keinen unmittelbaren mechanischen Kontakt aufweisen.

Die elektrischen Leiter sind insbesondere zumindest bereichsweise als Leiterbänder ausgebildet. Mit anderen Worten umfassen die elektrischen Leiter insbesondere einen im wesentlichen ebenen Bereich, der ausgelegt ist, im wesentlichen formschlüssig mit einem Anschluß einer Diode zu kontaktieren. Die Überbrückungseinrichtung weist über die mit der Diode verbundenen elektrischen Leiter hinaus keine weiteren elektrischen Kontakte auf, insbesondere keine weiteren Eingänge und/oder Ausgänge bzw. Anschlußpole, um die Überbrückungseinrichtung mit einer externen Einrichtung elektrisch zu verbinden.

Der Begriff "im wesentlichen" kann im Sinne der vorliegenden Erfindung eine Abweichung von einer gewünschten Eigenschaft beschreiben. Insbesondere kann dies eine Abweichung ohne signifikante Änderung der gewünschten Eigenschaft sein, beispielsweise, falls die gewünschte Eigenschaft als Solleigenschaft angesehen wird, kann "im wesentlichen" ein Abweichung von dieser Solleigenschaft um weniger als etwa 10%, weniger als etwa 5%, weniger als etwa 2%, insbesondere weniger als etwa 1% beschreiben.

Der Begriff "Kontakt" im Sinne der vorliegenden Erfindung beinhaltet insbesondere elektrischen und/oder mechanischen Kontakt, so daß eine Eingangs- bzw. Ausgangsanschlußdosenkontakteinrichtung ausgelegt ist einen elektrischen und/oder einen mechanischen Kontakt mit den elektrischen Leitern der Solarzelle herzustellen. Der unmittelbare Kontakt kann insbesondere durch Löten, Schweißen, Klemmen, Schrauben oder dergleichen hergestellt sein.

Mittels des Deckelements ist die Diode bevorzugt feuchtigkeitsdicht, insbesondere gemäß der Norm IP67, vom Äußeren des Solarmoduls, d.h. beispielsweise der Umgebungsatmosphäre abgeschlossen. Besonders bevorzugt umfaßt das Abdecken der Ausnehmung und der Diode auch ein fluiddichtes Verschließen der Ausnehmung bzw. ein fluiddichtes Einkapseln der Diode. Der durch das Deckelement sowie die Wandung der Ausnehmung begrenzte Raum wird im Sinne der Erfindung als Innenraum der Überbrückungseinrichtung bezeichnet.

### Bevorzugte Ausführungsformen des Solarpaneels

Vorzugsweise weist das Deckelement zumindest ein Befestigungselement auf, wobei das Deckelement mittels des zumindest einen Befestigungselements an dem Solarmodul befestigt ist. Bevorzugt ist das Deckelement einstückig ausgebildet, insbesondere aus einem Polymer bzw. einem elektrisch nicht leitenden Kunststoff.

Vorzugsweise umfaßt das Befestigungselement ein an dem Deckelement angeordnetes Haftmittel. Weiterhin vorzugsweise ist das Befestigungselement ein an dem Deckelement angeordnetes Haftmittel. Insbesondere kann das Befestigungselement eine Schicht Haftkleber, Schmelzkleber und/oder ein doppelseitiges Klebeband umfassen. Vorteilhafterweise ist das Deckelement dadurch materialsparend und einfach an dem Solarmodul zu befestigen. Aufgrund der geringen mechanischen Belastung des Deckelements, welches insbesondere keine Kabelanschlüsse umfaßt, so daß keine Zugbelastung auftritt, steht eine vereinfachte bzw. schwächere Befestigung des Deckelements einem sicheren Betrieb nicht entgegen.

Vorzugsweise umfaßt das Befestigungselement ein an dem Deckelement angeordnetes Rastmittel. Weiterhin vorzugsweise ist das Befestigungselement ein an dem Deckelement angeordnetes Rastmittel.

Vorzugsweise weist das Deckelement eine Einfüllöffnung auf. Bevorzugt können zusätzlich eine oder mehrere weitere Einfüllöffnungen im Deckelement vorgesehen sein. Insbesondere ist jede Einfüllöffnung dazu ausgelegt, eine Extrusionsdüse für flüssiges Kunstharz zu kontaktieren und/oder aufzunehmen. Dazu ist die Einfüllöffnung insbesondere kegelförmig ausgebildet.

Vorzugsweise weist das Deckelement eine Entlüftungsöffnung auf. Bevorzugt können zusätzlich eine oder mehrere weitere Entlüftungsöffnungen im Deckelement vorgesehen sein. Vorteilhafterweise kann mittels der zumindest einen Entlüftungsöffnung die im Innenraum der Überbrückungseinrichtung vorhandene Luft während des Ausgießens entweichen.

Vorzugsweise ist das Innere der zumindest einen Überbrückungseinrichtung feuchtigkeitsdichtend mit Kunstharz ausgegossen. Das Innere bzw. der Innenraum ist besonders bevorzugt mit einem isolierenden Harz ausgegossen, um die einzelnen Bestandteile der Überbrückungseinrichtung fest miteinander zu verbinden und elektrisch voneinander zu isolieren. Vorteilhafterweise ist durch das Ausgießen mit Kunstharz ein besonders guter Schutz vor eindringender Feuchtigkeit, z.B. nach der standardisierten Norm IP67 zu erreichen.

Weiterhin kann das Kunstharz auch dazu dienen, das entsprechende Deckelement an dem Solarmodul zu befestigen, wenn z.B. das Kunstharz eine chemische Verbindung mit dem Solarmodul bzw. dem Deckelement eingeht. In diesem Fall kann das Kunstharz als Haftmittel dienen. In diesem Fall kann die Diode an zwei elektrischen Leitern angeordnet und damit kontaktiert werden, wobei anschließend das Deckelement angeordnet werden und der somit gebildete Innenraum mit Kunstharz ausgegossen werden kann. Dadurch ist insbesondere eine innige Verbindung zwischen dem Deckelement und dem Kunstharz und dem Solarmodul bzw. dem Anschlußseitenelement herstellbar, wobei die Diode in das Kunstharz eingebettet ist. Es ist auch möglich, daß das Deckelement eine Halteeinrichtung aufweist, mit der die Diode sicher plaziert und gehalten werden kann, so daß die Anschlüsse der Diode z.B. beim Ausgießen des Inneren der Überbrückungseinrichtung mit Kunstharz mit den elektrischen Leitern sicher in elektrischen Kontakt bleiben.

Vorzugsweise umfaßt das Solarpaneel zwei oder mehr Überbrückungseinrichtungen. Beispielsweise umfaßt das Solarpaneel 2, 3, 4, 5, 6, usw. Überbrückungseinrichtungen.

Vorzugsweise ist die Diode eine SMD-Diode. Bevorzugt ist die SMD-Diode derart flach ausgebildet, daß der Diodenkörper eine Dicke kleiner oder gleich der Tiefe der Ausnehmung in dem Anschlußseitenelement aufweist. Vorteilhafterweise ist aufgrund der flachen Bauweise der SMD-Diode ein verbesserter mechanischer Kontakt zwischen dem elektrischen Leiter und der Diode ausgebildet. Insbesondere kann der Deckel entsprechend flach ausgebildet werden, wenn der Diodenkörper nicht aus der Ausnehmung herausragt. Weiter vorteilhafterweise ist der spezifische Wärmefluß aufgrund der vergrößerten Oberfläche der SMD-Diode gegenüber einer zylindrischen Koaxial-Diode bei gleicher Verlustleistung verringert, so daß die von der Diode ausgehende thermische Belastung der umliegenden Bauteile verringert ist. Da weiterhin genau eine Diode in jeder Überbrückungseinrichtung angeordnet ist, wird weiterhin vorteilhafterweise die lokale thermische Belastung in jeder Überbrückungseinrichtung gegenüber einer konventionellen Anschlußdose mit einer Vielzahl von Dioden verringert. Das Gehäuse der SMD-Diode ist insbesondere für die Oberflächenmontage der Diode ausgelegt. Bevorzugt sind die zumindest zwei Anschlüsse der SMD-Diode an der Seite des Gehäuses angeordnet, welche bei der Montage der SMD-Diode den elektrischen Leitern des Solarmoduls zugewandt ist.

Vorzugsweise umfaßt das Solarpaneel:
- eine elektrische Eingangsanschlußdose, welche genau einen elektrischen Verbinder mit einem Anschlußpol aufweist, der mit einem Eingangsanschlußleiter des Solarpaneels kontaktiert ist,
- eine elektrische Ausgangsanschlußdose, welche genau einen elektrischen Verbinder mit einem Anschlußpol aufweist, der mit einem Ausgangsanschlußleiter des Solarpaneels kontaktiert ist,
wobei die Eingangsanschlußdose, die Ausgangsanschlußdose und die zumindest eine Überbrückungseinrichtung jeweils paarweise voneinander beabstandet an dem Solarmodul befestigt sind.

Die Eingangs- und Ausgangsanschlußdose sind an der Anschlußseite bzw. - fläche des Solarmoduls voneinander beabstandet befestigt, insbesondere durch Verkleben mit dem Solarmodul.

Der Begriff "beabstandet" insbesondere in Bezug auf die Beabstandung der Eingangs- und Ausgangsanschlußdose beschreibt im Sinne der Erfindung, daß zwischen der Eingangsanschlußdose und der Ausgangsanschlußdose ein lichter Abstand von vorzugsweise mehr als etwa 1 cm, mehr als etwa 5 cm, mehr als etwa 10 cm, mehr als etwa 50 cm und besonders bevorzugt mehr als etwa 1 m besteht. Der Abstand wird durch die Abmessung des Solarmoduls begrenzt. Der Begriff der "paarweisen Beabstandung" bedeutet im Sinne der Erfindung, daß zwei beliebig ausgewählte Elemente einer Menge, d.h. aus der Menge der Eingangs- und Ausgangsanschlußdosen sowie der Überbrückungseinrichtung(en), voneinander beabstandet sind.

Die Anschlußpole der Eingangs- und Ausgangsanschlußdosen sind über das Solarmodul miteinander elektrisch verbunden, wobei die Eingangs- und Ausgangsanschlußdosen dadurch definiert sind, daß der elektrische Strom von der Eingangsanschlußdose in Richtung der Ausgangsanschlußdose fließt, wenn das Solarpaneel in betriebsmäßigem Gebrauch ist. In anderen Worten können die Anschlußpole der Eingangsanschlußdose und die Ausgangsanschlußdose die beiden Pole des Solarpaneels bilden, d.h. der Anschlußpol der Ausgangsanschlußdose kann der Pluspol sein und der Anschlußpol der Eingangsanschlußdose kann der Minuspol sein, so daß der Strom durch einen an das Solarpaneel angeschlossenen Verbraucher vom Pluspol zum Minuspol fließt. Die Terminologie kann auch umgedreht werden.

Vorteilhafterweise sind die Eingangs- und Ausgangsanschlußdosen einfach zu montieren und können unabhängig voneinander an beliebigen Stellen des Solarmoduls befestigt werden. Dadurch ist es vorteilhafterweise möglich die Eingangsanschlußdose z.B. an einem zur Ausgangsanschlußdose entgegengesetzten Ende des Solarmoduls anzuordnen. Werden mehrere solcher Solarpaneele nebeneinander in einer Solaranlage installiert, kann eine Ausgangsanschlußdose eines ersten Solarpaneels benachbart zu einer Eingangsanschlußdose eines zweiten Solarpaneels angeordnet sein. Dadurch können die Kabelverbindungen zwischen den zwei Solarpaneelen vorteilhafterweise minimiert werden, wodurch sich eine Materialersparnis und eine Erleichterung der Montage der Solaranlage ergibt.

Vorzugsweise weist die Eingangsanschlußdose genau ein Kabel mit genau einer Leitungsader auf, die mit dem Eingangsanschlußleiter kontaktiert ist, und/oder weist die Ausgangsanschlußdose genau ein Kabel mit genau einer Leitungsader auf, die mit dem Ausgangsanschlußleiter kontaktiert ist.

Vorteilhafterweise kann die elektrische Kontaktierung des Solarpaneels mittels des oder der Kabel besonders betriebssicher hergestellt werden, wobei insbesondere eine erhöhte Feuchtigkeitsdichtigkeit in einfacher Weise erreicht werden kann. Hierbei kann eine Zugentlastung des Kabels fest mit der Eingangs- und/oder der Ausgangsanschlußdose verbunden, insbesondere verklebt sein. Analog zu der vorangehenden Beschreibung stellt ein Kabel lediglich jeweils einen Anschlußpol bereit, d.h. einen Pluspol oder einen Minuspol des Solarpaneels, so daß ein Kabel lediglich eine Leitungsader aufweist.

Besonders bevorzugt kann zur Kontaktierung bzw. zum Anschluß des Solarpaneels ein Verbinder und ein Kabel vorgesehen sein, wobei die Eingangsanschlußdose einen Verbinder und die Ausgangsanschlußdose ein Kabel aufweist. Alternativ kann die Eingangsanschlußdose ein Kabel und die Ausgangsanschlußdose einen Verbinder aufweisen. Insbesondere kann das Kabel an seinem zur Eingangs- bzw. Ausgangsdose distalen Ende weiter einen komplementären Verbinder aufweisen, der ausgelegt ist, mit dem Verbinder der Ausgangs- bzw. Eingangsdose eines zweiten Solarpaneels verbunden bzw. kontaktiert zu werden.

Eine oder mehrere Überbrückungseinrichtung(en) kann/können am Anschlußseitenelement des Solarmoduls voneinander und von der Eingangs- und Ausgangsanschlußdose beabstandet befestigt sein. Insbesondere kann/können die Überbrückungseinrichtung(en) entlang der Verbindungslinie zwischen der Eingangs- und Ausgangsanschlußdose befestigt sein.

### Verfahren zum Herstellen eines Solarpaneels gemäß einem Aspekt

Ein Aspekt der vorliegenden Erfindung betrifft ein Verfahren zum Herstellen eines Solarpaneels, umfassend die Schritte:
- Bereitstellen eines Solarmoduls mit
   -- einem Anschlußseitenelement, in dem zumindest eine Ausnehmung ausgebildet ist und
   -- zumindest zwei elektrischen Leitern, die zumindest bereichsweise in der Ausnehmung angeordnet sind,
- Bereitstellen zumindest einer Diode,
- Kontaktieren eines ersten der elektrischen Leiter unmittelbar mit einem zugeordneten ersten Anschluß der Diode
- Kontaktieren eines zweiten der elektrischen Leiter unmittelbar mit einem zugeordneten zweiten Anschluß der Diode, so daß die zwei elektrischen Leiter mittels der zumindest einen Diode elektrisch verbunden sind,
- Befestigen eines Deckelements an dem Anschlußseitenelement, wobei die Ausnehmung und die zumindest eine Diode abgedeckt werden.

Durch die obigen Schritte bilden das Deckelement, die Ausnehmung und die zumindest eine Diode vorteilhafterweise auf einfache und materialsparende Art und Weise eine Überbrückungseinrichtung aus.

Vorzugsweise umfaßt das Verfahren den Schritt: Ausgießen eines Inneren einer Überbrückungseinrichtung mit Kunstharz, wobei die Überbrückungseinrichtung durch die Ausnehmung in dem Anschlußseitenelement, die zumindest eine Diode sowie das Deckelement ausgebildet wird. Insbesondere erfolgt das Ausgießen des Inneren mit Kunstharz durch die Öffnung des entsprechenden Deckelements.

Bevorzugt umfaßt das Ausgießen des Inneren der Überbrückungseinrichtung das im wesentlichen fluiddichte, insbesondere wasserdichte und/oder luftdichte, Abdichten bzw. Verschließen des Inneren der Überbrückungseinrichtung. Die Diode und die damit verbunden elektrischen Leiter sind dadurch vorteilhafterweise vor Umwelteinflüssen, insbesondere vor Feuchtigkeit, geschützt. Weiter bevorzugt umfaßt das Ausgießen ebenfalls die Befestigung des Deckelements an dem Solarmodul bzw. an dem Anschlußseitenelement.

Vorzugsweise umfaßt das Verfahren die Schritte:
- Bereitstellen einer elektrischen Eingangsanschlußdose mit genau einem elektrischen Verbinder mit einem Anschlußpol und Kontaktieren des Anschlußpols mit einem Eingangsanschlußleiter des Solarpaneels,
- Bereitstellen einer elektrischen Ausgangsanschlußdose mit genau einem elektrischen Verbinder mit einem Anschlußpol und Kontaktieren des Anschlußpols mit einem Ausgangsanschlußleiter des Solarpaneels,
- Befestigen der Eingangsanschlußdose und der Ausgangsanschlußdose an dem Solarpaneel, wobei die Eingangsanschlußdose, die Ausgangsanschlußdose und die Überbrückungseinrichtung jeweils paarweise voneinander beabstandet sind.

Das Befestigen der Eingangs- bzw. Ausgangsanschlußdose kann insbesondere mittels eines Klebemittels erfolgen. Das Befestigen kann beispielsweise ein Auftragen, insbesondere ein Aufsprühen eines verformbaren, insbesondere flüssigen Klebers an bzw. auf einer Kontaktfläche der Eingangs- und/oder Ausgangsanschlußdose umfassen, mit welcher die Eingangs- und/oder Ausgangsanschlußdose mit dem Solarmodul in Kontakt tritt. Der Kleber kann beispielsweise die Kontaktfläche vollständig bedecken. Es ist auch möglich, daß der Kleber lediglich an diskreten Punkten bzw. Flächen auf bzw. an der Kontaktfläche aufgetragen ist. Weiterhin kann das Befestigen der entsprechenden Dose an dem Solarmodul beinhalten, daß der Kleber seine klebende bzw. haftende Eigenschaft erhält. Der Kleber kann z.B. mit Wärme und/oder mit Licht behandelt werden, wie z.B. mit UV Licht bestrahlt werden.

Das Kontaktieren des Anschlußpols der Eingangs- oder Ausgangsanschlußdose mit dem zugeordneten Eingangs- oder Ausgangsanschlußleiter des Solarpaneels, kann vorzugsweise durch Schweißen, Löten, Kleben, Verkrimpen, usw. erfolgen.

Die Erfindung ist nicht auf die oben beschriebenen Aspekte bzw. Ausführungsformen beschränkt. Vielmehr können einzelne Merkmale der Aspekte und/oder Ausführungsformen beliebig miteinander kombiniert werden und insbesondere somit neue Ausführungsformen gebildet werden. In anderen Worten gelten die obigen Ausführungen zu den einzelnen Merkmalen der Vorrichtung sinngemäß auch für das Verfahren und umgekehrt.

### Figurenbeschreibung

Nachfolgend werden bevorzugte Ausführungsformen der vorliegenden Erfindung anhand der beigefügten Zeichnungen beispielhaft erläutert. Es zeigt:
- Figur 1:: eine perspektivische Ansicht einer bevorzugten Ausführungsform eines Solarpaneels in teilbestücktem Zustand;
- Figur 2:: eine perspektivische Explosionsdarstellung eine bevorzugte Ausführungsform einer Überbrückungseinrichtung;
- Figur 3:: eine weitere perspektivische der Überbrückungseinrichtung;
- Figur 4:: einen Querschnitt durch die Überbrückungseinrichtung.

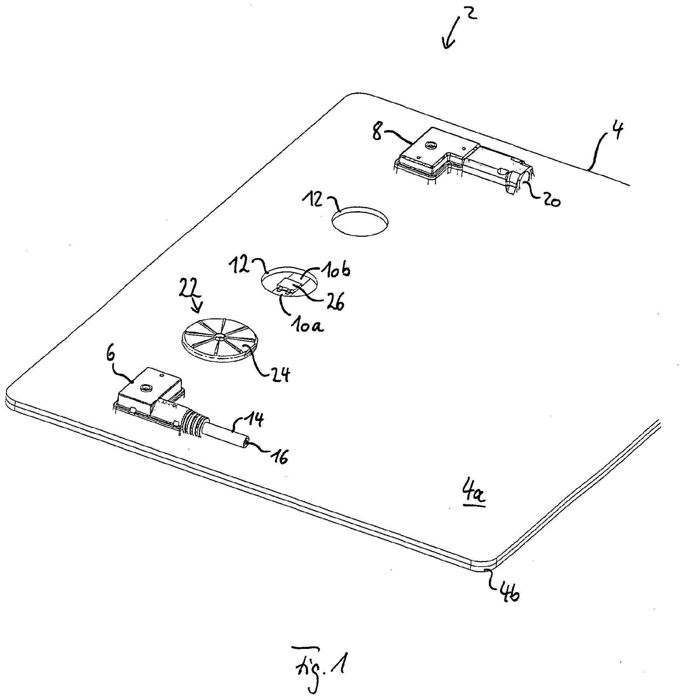

**Figur 1** zeigt eine perspektivische Ansicht einer bevorzugten Ausführungsform eines Solarpaneels 2 in teilbestücktem Zustand. Das gezeigte Solarpaneel 2 umfaßt ein Solarmodul 4 mit einem Anschlußseitenelement 4a und einem Beleuchtungsseitenelement 4b, eine Eingangsanschlußdose 6 und eine Ausgangsanschlußdose 8.

In der Figur 1 sind zwei elektrische Leiter 10a, 10b gezeigt, die in einer Ausnehmung 12 des Anschlußseitenelements 4a des Solarmoduls 4 angeordnet sind. Die elektrischen Leiter 10a, 10b ragen bereichsweise in die Ausnehmung 12. Die Leiter 10a, 10b sind in das Solarmodul 4 eingebettet und mit einer Solarzelle (nicht gezeigt) elektrisch verbunden. Die zwei elektrischen Leiter 10a, 10b sind mittels der als SMD-Diode ausgeführten Diode 26 elektrisch miteinander kontaktiert. Die Anschlüsse der Diode 26 sind durch Verlöten unmittelbar mit den elektrische Leitern 10a, 10b kontaktiert.

Vorzugsweise ist die Diode 26 derart flach ausgebildet, daß die Diode 26 nicht aus der Ausnehmung 12 herausragt, d.h. der Diodenkörper eine Dicke kleiner oder gleich der Tiefe der Ausnehmung 12 in dem Anschlußseitenelement 4a aufweist. Ein zum Abdecken bzw. Verschließen der Ausnehmung auf diese anzuordnendes Deckelement 24 kann in dann vorteilhafterweise entsprechend flach ausgebildet werden. Nach dem Anordnen des Deckelements 24 wird durch das Deckelement 24, die Diode 26, die elektrischen Leiter 10a, 10b sowie die Wandung der Ausnehmung 12 eine Überbrückungseinrichtung 22 ausgebildet, wobei ein Raum begrenzt wird, der als Innenraum der Überbrückungseinrichtung 22 bezeichnet wird.

Ein elektrischer Leiter (nicht gezeigt) ist mit dem Anschlußpol der bereits befestigten Eingangsanschlußdose 6 kontaktiert, wobei der Anschlußpol in einer bevorzugten Ausführungsform als Leitungsader 16 eines Kabels 14 ausgebildet ist. Ein weiterer elektrischer Leiter (nicht gezeigt) ist mit dem Anschlußpol der bereits befestigten Ausgangsanschlußdose 8 kontaktiert, wobei der Anschlußpol in einer bevorzugten Ausführungsform als Verbinder 20 ausgebildet ist.

Die Eingangsanschlußdose 6 und die Ausgangsanschlußdose 8 sind in dieser Ausführungsform mit ihren Grundseiten mit dem Anschlußseitenelement 4a des Solarmoduls 4 verklebt. Das Kabel 14 mit genau einer Leitungsader 16 ist mit der Eingangsanschlußdose 6 fest verbunden. Der Verbinder 20 der Ausgangsanschlußdose 8 weist genau einem Anschlußpol auf.

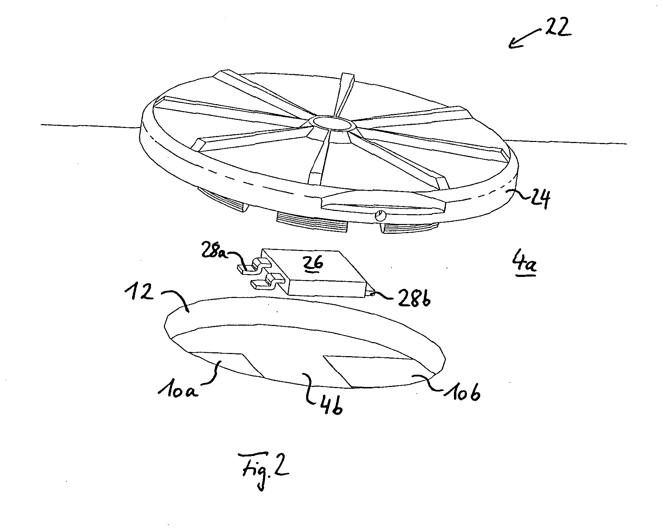

**Figur 2** zeigt eine perspektivische Explosionsdarstellung einer bevorzugten Ausführungsform einer Überbrückungseinrichtung 22. Die Überbrückungseinrichtung 22 umfaßt die Ausnehmung 12, die in der Ausnehmung 12 angeordneten elektrischen Leiter 10a, 10b, die Diode 26 mit einem ersten Anschluß 28a und einem zweiten Anschluß 28b sowie ein Deckelement 24. Ebenso sind das Anschlußseitenelement 4a als auch das Beleuchtungsseitenelement 4b gezeigt, wobei das Beleuchtungsseitenelement 4b eine Rückseite der Überbrückungseinrichtung 22 bildet.

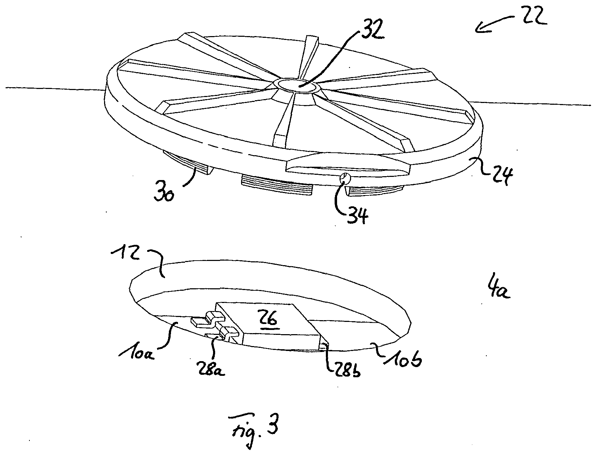

Wie in **Figur 3** gezeigt ist, wird der elektrische Leiter 10a unmittelbar durch Verlöten mit dem zugeordneten ersten Anschluß 28a der Diode 26 kontaktiert. Analog wird der elektrische Leiter 10b ebenfalls unmittelbar durch Verlöten mit dem zugeordneten zweiten Anschluß 28b der Diode 26 kontaktiert.

Anschließend wird das Deckelements 24 an dem Anschlußseitenelement 4a befestigt, so daß Ausnehmung 12 abgedeckt bzw. verschlossen wird. Das Deckelements 24 weist in dieser Ausführungsform eine Vielzahl von Rastelementen 30, als bevorzugten Befestigungselementen, auf, welche ausgelegt sind mit der Wandung der Ausnehmung 12 in Reibschluß zu gelangen, so daß das Deckelement 24 nicht unbeabsichtigt von der Ausnehmung 12 entfernt werden kann.

Zur weiteren Befestigung des Deckelements 24 kann das Inneren des durch das Deckelement 24 und die Ausnehmung 12 gebildeten Raumes mit Kunstharz ausgegossen werden. Dadurch werden das Deckelement 24 und die Diode 26 fest in der Ausnehmung 12 befestigt bzw. verankert. Vorteilhafterweise ist durch das Ausgießen mit Kunstharz ein besonders guter Schutz vor eindringender Feuchtigkeit erreichbar.

Um ein Ausgießen mit Kunstharz zu erleichtern weist das Deckelement 24 vorzugsweise zumindest eine Einfüllöffnung 32 auf, welche insbesondere kegelförmig ausgebildet ist. Weiter bevorzugt können zusätzlich eine oder mehrere weitere Entlüftungsöffnungen 34 im Deckelement 24 vorgesehen sein, so daß die Luft während des Ausgießens durch das Deckelement 24 entweichen kann.

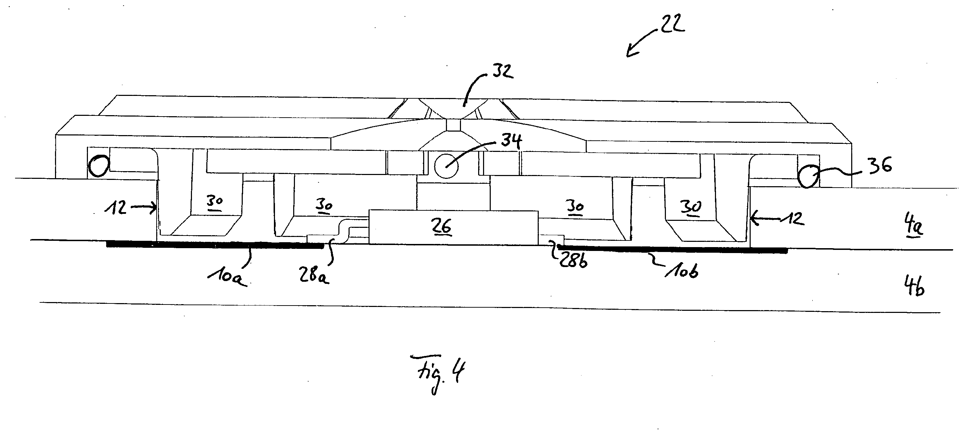

**Figur 4** zeigt eine Querschnittsansicht durch die Überbrückungseinrichtung 22. Die elektrischen Leiter 10a, 10b sind unmittelbar durch Verlöten mit den zugeordneten Anschlüssen 28a, 28b der Diode 26 kontaktiert. Das Deckelement 24 ist mittels der Rastelemente 30 durch Reibschluß mit der Wandung der Ausnehmungs 12 an dem Anschlußseitenelement 4a befestigt. Die Ausnehmung 12 und die Diode 26 ist durch das Deckelement abgedeckt bzw. verschlossen. Die durch die Wandung der Ausnehmung 12, das Deckelement 24 und die Diode 26 ausgebildete Überbrückungseinrichtung 22 kann in einem folgenden Schritt mit einem Kunstharz ausgegossen werden.

Das Deckelement 24 weist eine trichterförmige Einfüllöffnung 32 auf, durch die in einem folgenden Schritt Kunstharz in das Innere der Überbrückungseinrichtung 22 gefüllt werden kann. Folglich ist es möglich, daß die Überbrückungseinrichtung 22 mittels eines Haftmittels, z.B. eines Klebebandes, an dem Anschlußseitenelement 4a fixiert wird und anschließend das Innere mit dem Kunstharz ausgegossen wird. Durch das Kunstharz wird die Überbrückungseinrichtung 22 an dem Solarmodul 4 zusätzlich fixiert. Es ist auch möglich, daß die Überbrückungseinrichtung 22 mit einem Werkzeug angeordnet und gehalten wird, bis das Innere der Überbrückungseinrichtung 22 mit Kunstharz gefüllt ist und das Kunstharz soweit gehärtet ist, daß die Überbrückungseinrichtung 22 am Solarmodul 4 befestigt ist.

Zusätzlich oder alternativ kann auch ein Dichtungselement 36, z.B. in Form eines O-Rings an dem Deckelement 24 angeordnet sein, so daß das Innere der Überbrückungseinrichtung 22 feuchtigkeitsdicht gegenüber der Umgebungsatmosphäre abgeschlossen wird. Hierbei kann das Deckelement 24 vollständig geschlossen sein, d.h. insbesondere ohne die Einfüllöffnung 32 und ohne die Entlüftungsöffnung(en) 34 ausgebildet sein. Somit kann vermieden werden, daß das Innere der Überbrückungseinrichtung mit einem Kunstharz gefüllt werden muß.

### Bezugszeichenliste

- 2: Solarpaneel
- 4: Solarmodul
- 4a: Anschlußseitenelement
- 4b: Beleuchtungsseitenelement
- 6: Eingangsanschlußdose
- 8: Ausgangsanschlußdose
- 10a, 10b: elektrische Leiter
- 12: Ausnehmung
- 14: Kabel
- 16: Leitungsader
- 20: Verbinder
- 22: Überbrückungseinrichtung
- 24: Deckelement
- 26: Diode
- 28a, 28b: Anschluß der Diode
- 30: Rastelement
- 32: Einfüllöffnung
- 34: Entlüftungsöffnung
- 36: Dichtungselement

## Patentansprüche

1. Solarpaneel, umfassend:
- ein Solarmodul (4) mit einem Anschlußseitenelement (4a), wobei das Solarmodul (4) zumindest zwei in Reihe geschaltete Solarzellen umfasst, wobei jede Solarzelle zwei elektrische Leiter (10a, 10b) aufweist, die den Plus- und Minuspol der Solarzelle bilden,
- zumindest eine elektrische Überbrückungseinrichtung (22), umfassend:
-- eine Ausnehmung (12), die in dem Anschlußseitenelement (4a) ausgebildet ist,
-- wobei in der Ausnehmung (12) ein erster und zweiter der elektrischen Leiter (10a, 10b) des Solarmoduls (4), die den Plus- und Minuspol einer der Solarzellen bilden, zumindest bereichsweise angeordnet sind,
-- eine Diode (26),
wobei der erste der elektrischen Leiter (10a) einen zugeordneten ersten Anschluß (28a) der Diode (26) unmittelbar kontaktiert und
wobei der zweite der elektrischen Leiter (10b) einen zugeordneten zweiten Anschluß (28b) der Diode (26) unmittelbar kontaktiert,
so daß die zwei elektrischen Leiter (10a, 10b) mittels der Diode (26) elektrisch verbunden sind, und
-- ein Deckelement (24), welches an dem Anschlußseitenelement (4a) befestigt ist und die Ausnehmung (12) sowie die Diode (26) abdeckt,
wobei die zumindest eine Überbrückungseinrichtung (22) über die mit der Diode verbundenen elektrischen Leiter hinaus keine weiteren elektrischen Kontakte aufweist, um die zumindest eine Überbrückungseinrichtung mit einer externen Einrichtung elektrisch zu verbinden.

2. Solarpaneel nach Anspruch 1, wobei das Deckelement (24) zumindest ein Befestigungselement (30) aufweist und das Deckelement (24) mittels des zumindest einen Befestigungselements (30) an dem Solarmodul (4) befestigt ist.

3. Solarpaneel nach Anspruch 2, wobei das Befestigungselement (30) ein an dem Deckelement (24) angeordnetes Haftmittel umfaßt.

4. Solarpaneel nach Anspruch 2 oder 3, wobei das Befestigungselement (30) ein an dem Deckelement (24) angeordnetes Rastmittel (30) umfaßt.

5. Solarpaneel nach einem der vorherigen Ansprüche, wobei das Deckelement (24) eine Einfüllöffnung (32) aufweist.

6. Solarpaneel nach einem der vorherigen Ansprüche, wobei das Deckelement (24) eine Entlüftungsöffnung (34) aufweist.

7. Solarpaneel nach einem der vorherigen Ansprüche, wobei das Innere der zumindest einen Überbrückungseinrichtung (22) feuchtigkeitsdichtend mit Kunstharz ausgegossen ist.

8. Solarpaneel nach einem der vorherigen Ansprüche, wobei das Solarpaneel (2) zwei oder mehr Überbrückungseinrichtungen (22) umfaßt.

9. Solarpaneel nach einem der vorherigen Ansprüche, wobei die Diode (26) eine SMD-Diode (26) ist.

10. Solarpaneel nach einem der vorherigen Ansprüche, weiter umfassend:
- eine elektrische Eingangsanschlußdose (6), welche genau einen elektrischen Verbinder mit einem Anschlußpol aufweist, der mit einem Eingangsanschlußleiter des Solarpaneels kontaktiert ist,
- eine elektrische Ausgangsanschlußdose (8), welche genau einen elektrischen Verbinder (20) mit einem Anschlußpol aufweist, der mit einem Ausgangsanschlußleiter des Solarpaneels kontaktiert ist,
wobei die Eingangsanschlußdose (6), die Ausgangsanschlußdose (8) und die zumindest eine Überbrückungseinrichtung (22) jeweils paarweise voneinander beabstandet an dem Solarmodul (4) befestigt sind.

11. Solarpaneel nach Anspruch 10, wobei die Eingangsanschlußdose (6) genau ein Kabel (14) mit genau einer Leitungsader (16) aufweist, die mit dem Eingangsanschlußleiter kontaktiert ist, und/oder die Ausgangsanschlußdose (8) genau ein Kabel mit genau einer Leitungsader aufweist, die mit dem Ausgangsanschlußleiter kontaktiert ist.

12. Verfahren zum Herstellen eines Solarpaneels (2), umfassend die Schritte:
- Bereitstellen eines Solarmoduls (4) mit einem Anschlußseitenelement (4a), in dem zumindest eine Ausnehmung (12) ausgebildet ist, wobei das Solarmodul (4) zumindest zwei in Reihe geschaltete Solarzellen umfasst, wobei jede Solarzelle zwei elektrische Leiter (10a, 10b) aufweist, die den Plus- und Minuspol der Solarzellen bilden, und wobei in jeder der zumindest einen Ausnehmung ein erster und zweiter der elektrischen Leiter (10a, 10b), die den Plus- und Minuspol einer der Solarzellen bilden, zumindest bereichsweise angeordnet sind, und
- Bereitstellen zumindest einer elektrischen Überbrückungseinrichtung (22) für jede der zumindest einen Ausnehmung, umfassend die Schritte:
-- Bereitstellen einer Diode (26),
-- Kontaktieren des ersten der elektrischen Leiters (10a) unmittelbar mit einem zugeordneten ersten Anschluß (28a) der Diode (26)
-- Kontaktieren des zweiten der elektrischen Leiter (10b) unmittelbar mit einem zugeordneten zweiten Anschluß (28b) der Diode (26), so daß die zwei elektrischen Leiter (10a, 10b) mittels der zumindest einen Diode (26) elektrisch verbunden sind,
-- Befestigen eines Deckelements (24) an dem Anschlußseitenelement (4a), wobei die Ausnehmung (12) und die zumindest eine Diode (26) abgedeckt werden,
wobei die Überbrückungseinrichtung (22) über die mit der Diode verbundenen elektrischen Leiter hinaus keine weiteren elektrischen Kontakte aufweist, um die Überbrückungseinrichtung mit einer externen Einrichtung elektrisch zu verbinden.

13. Verfahren nach Anspruch 12, weiter umfassend den Schritt:
- Ausgießen eines Inneren der Überbrückungseinrichtung (22) mit Kunstharz, wobei die Überbrückungseinrichtung (22) durch die Ausnehmung (12) in dem Anschlußseitenelement (4a), die Diode (26) sowie das Deckelement (24) ausgebildet wird.

14. Verfahren nach Anspruch 12 oder 13, weiter umfassend die Schritte:
- Bereitstellen einer elektrischen Eingangsanschlußdose (6) mit genau einem elektrischen Verbinder mit einem Anschlußpol und Kontaktieren des Anschlußpol mit einem Eingangsanschlußleiter des Solarpaneels,
- Bereitstellen einer elektrischen Ausgangsanschlußdose (8) mit genau einem elektrischen Verbinder mit einem Anschlußpol und Kontaktieren des Anschlußpol mit einem Ausgangsanschlußleiter des Solarpaneels,
- Befestigen der Eingangsanschlußdose (6) und der Ausgangsanschlußdose (8) an dem Solarpaneel, wobei die Eingangsanschlußdose (6), die Ausgangsanschlußdose (8) und die Überbrückungseinrichtung (22) jeweils paarweise voneinander beabstandet sind.

## Claims

1. A solar panel comprising:
- a solar module (4) with a connecting side member (4a), wherein the solar module (4) comprises at least two solar cells connected in series, wherein each solar cell has two electrical conductors (10a, 10b), which form the positive and negative pole of the solar cell,
- at least one electrical bridging apparatus (22) comprising:
-- a recess (12), which is formed in the connecting side member (4a),
-- wherein, in the recess (12), a first and second of the electrical conductors (10a, 10b) of the solar module (4), which form the positive and negative pole of one of the solar cells, are arranged, at least in areas,
-- a diode (26),
wherein the first of the electrical conductors (10a) directly contacts an assigned first connection (28a) of the diode (26) and wherein the second of the electrical conductors (10b) directly contacts an assigned second connection (28b) of the diode (26), so that the two electrical conductors (10a, 10b) are electrically connected by means of the diode (26), and
-- a covering member (24), which is fastened to the connecting side member (4a) and covers the recess (12) and the diode (26),
wherein the at least one bridging apparatus (22) has no further electrical contacts beyond the electrical conductors connected to the diode, in order to electrically connect the at least one bridging apparatus to an external apparatus.

2. The solar panel according to claim 1, wherein the covering member (24) has at least one fastening member (30) and the covering member (24) is fastened to the solar module (4) by means of the at least one fastening member (30).

3. The solar panel according to claim 2, wherein the fastening member (30) comprises a fixing means arranged on the covering member (24).

4. The solar panel according to claim 2 or 3, wherein the fastening member (30) comprises a latching means (30) arranged on the covering member (24).

5. The solar panel according to one of the preceding claims, wherein the covering member (24) has a filling opening (32).

6. The solar panel according to one of the preceding claims, wherein the covering member (24) has a ventilation opening (34).

7. The solar panel according to one of the preceding claims, wherein the inside of the at least one bridging apparatus (22) is filled with synthetic resin in a damp-proof manner.

8. The solar panel according to one of the preceding claims, wherein the solar panel (2) comprises two or more bridging apparatuses (22).

9. The solar panel according to one of the preceding claims, wherein the diode (26) is an SMD diode (26).

10. The solar panel according to one of the preceding claims, further comprising:
- an electrical input connecting socket (6), which has exactly one electrical connector with a connecting pole, which is contacted to an input connecting conductor of the solar panel,
- an electrical output connecting socket (8), which has exactly one electrical connector (20) with a connecting pole, which is contacted to an output connecting conductor of the solar panel,
wherein the input connecting socket (6), the output connecting socket (8) and the at least one bridging apparatus (22) are each fastened to the solar module (4) spaced apart from each other in pairs.

11. The solar panel according to claim 10, wherein the input connecting socket (6) has exactly one cable (14) with exactly one conducting wire (16) which is contacted to the input connecting conductor, and/or the output connecting socket (8) has exactly one cable with exactly one conducting wire which is contacted to the output connecting conductor.

12. A method for manufacturing a solar panel (2), comprising the steps:
- Providing a solar module (4) with a connecting side member (4a), in which at least one recess (12) is formed, wherein the solar module (4) comprises at least two solar cells connected in series, wherein each solar cell has two electrical conductors (10a, 10b), which form the positive and negative pole of one of the solar cells, and wherein, in each of the at least one recess, a first and second of the electrical conductors (10a, 10b), which form the positive and negative pole of the solar cell, are arranged, at least in areas, and
- Providing at least one electrical bridging apparatus (22) for each of the at least one recess, comprising the steps:
-- Providing a diode (26),
-- Contacting the first of the electrical conductors (10a) directly to an assigned first connection (28a) of the diode (26)
-- Contacting the second of the electrical conductors (10b) directly to an assigned second connection (28b) of the diode (26), so that the two electrical conductors (10a, 10b) are electrically connected by means of the at least one diode (26),
-- Fastening a covering member (24) to the connecting side member (4a), wherein the recess (12) and the at least one diode (26) are covered,
wherein the bridging apparatus (22) has no further electrical contacts beyond the electrical conductors connected to the diode, in order to electrically connect the bridging apparatus to an external apparatus.

13. The method according to claim 12, further comprising the step:
- Filling an inside of the bridging apparatus (22) with synthetic resin, wherein the bridging apparatus (22) is formed through the recess (12) in the connecting side member (4a), the diode (26) and the covering member (24).

14. The method according to claim 12 or 13, further comprising the steps:
- Providing an electrical input connecting socket (6) with exactly one electrical connector with a connecting pole and contacting the connecting pole to an input connecting conductor of the solar panel,
- Providing an electrical output connecting socket (8) with exactly one electrical connector with a connecting pole and contacting the connecting pole to an output connecting conductor of the solar panel,
- Fastening the input connecting socket (6) and the output connecting socket (8) to the solar panel, wherein the input connecting socket (6), the output connecting socket (8) and the bridging apparatus (22) are each spaced apart from each other in pairs.

## Revendications

1. Panneau solaire comprenant :
- un module solaire (4) avec un élément côté de raccord (4a), dans lequel le module solaire (4) comprend au moins deux cellules solaires montées en série, dans lequel chaque cellule solaire présente deux conducteurs électriques (10a, 10b) qui forment le pôle positif et négatif de la cellule solaire,
- au moins un dispositif de pontage électrique (22) comprenant :
-- un évidement (12) qui est réalisé dans l'élément côté de raccord (4a),
-- dans lequel un premier et un second des conducteurs électriques (10a, 10b) du module solaire (4) qui forment le pôle positif et négatif d'une des cellules solaires sont disposés au moins par région dans l'évidement (12),
-- une diode (26),
dans lequel le premier des conducteurs électriques (10a) vient directement en contact avec un premier raccord associé (28a) de la diode (26) et
dans lequel le second des conducteurs électriques (10b) vient directement en contact avec un second raccord associé (28b) de la diode (26),
de sorte que les deux conducteurs électriques (10a, 10b) sont électriquement reliés au moyen de la diode (26), et
-- un élément de recouvrement (24) qui est fixé à l'élément côté de raccord (4a) et recouvre l'évidement (12) ainsi que la diode (26),
dans lequel l'au moins un dispositif de pontage (22) ne présente aucun autre contact électrique au-delà des conducteurs électriques reliés à la diode pour relier électriquement l'au moins un dispositif de pontage à un dispositif externe.

2. Panneau solaire selon la revendication 1, dans lequel l'élément de recouvrement (24) présente au moins un élément de fixation (30) et l'élément de recouvrement (24) est fixé au module solaire (4) au moyen de l'au moins un élément de fixation (30).

3. Panneau solaire selon la revendication 2, dans lequel l'élément de fixation (30) comprend un moyen d'adhésion disposé sur l'élément de recouvrement (24).

4. Panneau solaire selon la revendication 2 ou 3, dans lequel l'élément de fixation (30) comprend un moyen d'encliquetage (30) disposé sur l'élément de recouvrement (24).

5. Panneau solaire selon une des revendications précédentes, dans lequel l'élément de recouvrement (24) présente une ouverture de remplissage (32).

6. Panneau solaire selon une des revendications précédentes, dans lequel l'élément de recouvrement (24) présente une ouverture de ventilation (34).

7. Panneau solaire selon une des revendications précédentes, dans lequel l'intérieur de l'au moins un dispositif de pontage (22) est coulé de résine synthétique de manière à l'étanchéifier contre l'humidité.

8. Panneau solaire selon une des revendications précédentes, dans lequel le panneau solaire (2) comprend deux dispositifs de pontage (22) ou plus.

9. Panneau solaire selon une des revendications précédentes, dans lequel la diode (26) est une diode CMS (26).

10. Panneau solaire selon une des revendications précédentes, comprenant en outre :
- une prise de courant d'entrée électrique (6) qui présente exactement un connecteur électrique avec un pôle de raccord qui vient en contact avec un conducteur de raccord d'entrée du panneau solaire,
- une prise de courant de sortie électrique (8) qui présente exactement un connecteur électrique (20) avec un pôle de raccord qui vient en contact avec un conducteur de raccord de sortie du panneau solaire,
dans lequel la prise de courant d'entrée (6), la prise de courant de sortie (8) et l'au moins un dispositif de pontage (22) sont chacun fixés par paire au module solaire (4) de manière espacée les uns des autres.

11. Panneau solaire selon la revendication 10, dans lequel la prise de courant d'entrée (6) présente exactement un câble (14) avec exactement un brin de ligne (16) qui vient en contact avec le conducteur de raccord d'entrée, et/ou la prise de courant de sortie (8) présente exactement un câble avec exactement un brin de ligne qui vient en contact avec le conducteur de raccord de sortie.

12. Procédé de fabrication d'un panneau solaire (2), comprenant les étapes :
- mise à disposition d'un module solaire (4) avec un élément côté de raccord (4a) dans lequel au moins un évidement (12) est réalisé, dans lequel le module solaire (4) comprend au moins deux cellules solaires montées en série, dans lequel chaque cellule solaire présente deux conducteurs électriques (10a, 10b) qui forment le pôle positif et négatif d'une des cellules solaires, et dans lequel un premier et un second des conducteurs électriques (10a, 10b) qui forment le pôle positif et négatif de la cellule solaire sont disposés au moins par région dans chacun de l'au moins un évidement, et
- mise à disposition d'au moins un dispositif de pontage électrique (22) pour chacun de l'au moins un évidement, comprenant les étapes :
-- mise à disposition d'une diode (26),
-- mise en contact du premier des conducteurs électriques (10a) directement avec un premier raccord associé (28a) de la diode (26),
-- mise en contact du second des conducteurs électriques (10b) directement avec un second raccord associé (28b) de la diode (26), de sorte que les deux conducteurs électriques (10a, 10b) sont électriquement reliés au moyen de l'au moins une diode (26),
-- fixation d'un élément de recouvrement (24) à l'élément côté de raccord (4a), dans lequel l'évidement (12) et l'au moins une diode (26) sont recouverts, dans lequel le dispositif de pontage (22) ne présente aucun autre contact électrique au-delà des conducteurs électriques reliés à la diode pour relier électriquement le dispositif de pontage à un dispositif externe.

13. Procédé selon la revendication 12, comprenant en outre l'étape :
- coulée d'un intérieur du dispositif de pontage (22) avec de la résine synthétique, dans lequel le dispositif de pontage (22) est réalisé à travers l'évidement (12) dans l'élément côté de raccord (4a), la diode (26) ainsi que l'élément de recouvrement (24).

14. Procédé selon la revendication 12 ou 13, comprenant en outre les étapes :
- mise à disposition d'une prise de courant d'entrée électrique (6) avec exactement un connecteur électrique avec un pôle de raccord et mise en contact du pôle de raccord avec un conducteur de raccord d'entrée du panneau solaire,
- mise à disposition d'une prise de courant de sortie électrique (8) avec exactement un connecteur électrique avec un pôle de raccord et mise en contact du pôle de raccord avec un conducteur de raccord de sortie du panneau solaire,
- fixation de la prise de courant d'entrée (6) et de la prise de courant de sortie (8) au panneau solaire, dans lequel la prise de courant d'entrée (6), la prise de courant de sortie (8) et le dispositif de pontage (22) sont chacun espacés les uns des autres par paire.
